# EUROPÄISCHE PATENTANMELDUNG

(11) **EP 2 902 757 A1**
(43) Veröffentlichungstag der Anmeldung: **05.08.2015**
(21) Anmeldenummer: 15152483.2
(22) Anmeldetag: 26.01.2015
(51) Int. Cl.: G01J 3/28, G01J 3/36, G01J 1/42, G01J 5/08, G01J 5/10, G01J 1/04

(54) **Optischer Sensor sowie Verfahren und Vorrichtung zum Herstellen eines optischen Sensors**

(30) Priorität: 04.02.2014 DE 102014201950
(71) Anmelder: ROBERT BOSCH GMBH, 70442 Stuttgart (DE)
(72) Erfinder: Schelling, Christoph, 70597 Stuttgart (DE)

(57) **Zusammenfassung**

Die Erfindung betrifft einen optischen Sensor (200) mit einem Fotometerelement (202) zum Erfassen zumindest eines Parameters einer ersten elektromagnetischen Strahlung, einem Infrarot-Sensorelement (204) zum Erfassen zumindest eines Parameters einer zweiten elektromagnetischen Strahlung und einer Auswerteeinheit (206) zum Auswerten des Parameters der ersten elektromagnetischen Strahlung und/oder des Parameters der zweiten elektromagnetischen Strahlung, wobei das Infrarot-Sensorelement (204) in und/oder an einem zwischen dem Fotometerelement (202) und der Auswerteeinheit (206) gebildeten Kavernenbereich (208) angeordnet ist.

## Beschreibung

### Stand der Technik

Die vorliegende Erfindung bezieht sich auf einen optischen Sensor und auf ein Verfahren sowie eine entsprechende Vorrichtung zum Herstellen eines optischen Sensors.

Heutige bildgebende optische Sensoren, z. B. Infrarot-Sensoren und Fotodioden, detektieren entweder Ferninfrarotlicht, sichtbares Licht im RGB-Bereich oder UV-Licht. Diese Sensoren werden heute als separate Bauelemente hergestellt und verbaut. Insbesondere in mobilen consumerendgeräten wie Mobiltelefonen gibt es einen Bedarf an multifunktionalen, kleinbauenden Sensorclustern.

### Offenbarung der Erfindung

Vor diesem Hintergrund werden mit dem hier vorgestellten Ansatz ein optischer Sensor, weiterhin ein Verfahren zum Herstellen eines optischen Sensors sowie eine Vorrichtung, die dieses Verfahren verwendet, gemäß den Hauptansprüchen vorgestellt. Vorteilhafte Ausgestaltungen ergeben sich aus den jeweiligen Unteransprüchen und der nachfolgenden Beschreibung.

Das hier vorgestellte Konzept erlaubt eine kostengünstige und platzsparende Realisierung sowohl einer Infrarot-Sensor- als auch einer Fotometer-Funktionalität in einem einzigen Clusterbauelement, wobei die (Fern-)Infrarot-Sensor-Funktionalität als Bolometer- oder als Pyrometerelement ausgeführt sein kann.

Ein gemäß dem hier vorgestellten Konzept realisierter optischer Sensor kann vorteilhaft in Modulbauweise gefertigt werden, indem die Auswerteeinheit und der Sensorchip separat gefertigt werden können und abschließend nur noch miteinander zu verbinden sind.

Es wird ein optischer Sensor mit einem Fotometerelement zum Erfassen zumindest eines Parameters einer ersten elektromagnetischen Strahlung, einem Infrarot-Sensorelement zum Erfassen zumindest eines Parameters einer zweiten elektromagnetischen Strahlung und einer Auswerteeinheit zum Auswerten des Parameters der ersten elektromagnetischen Strahlung und/oder des Parameters der zweiten elektromagnetischen Strahlung vorgestellt, wobei das Infrarot-Sensorelement in und/oder an einem zwischen dem Fotometerelement und der Auswerteeinheit gebildeten Kavernenbereich angeordnet ist.

Der optische Sensor kann zum Erfassen von Licht im sichtbaren Bereich und/oder im Ultraviolettbereich und/oder im Infrarot- bzw. Ferninfrarotbereich eingesetzt werden. Das Fotometerelement kann dabei beispielsweise zur Bildgebung (von im Wellenlängenbereich des sichtbaren Lichts) erkennbaren Objekten, beispielsweise in Form eines Belichtungsmessers, zur Verwendung kommen. Entsprechend kann es sich bei dem Parameter einer ersten elektromagnetischen Strahlung um eine Messgröße einer Lichtstrahlung, und damit einer elektromagnetischen Strahlung im kurzwelligeren Bereich, handeln. Das Infrarot-Sensorelement kann zur Erfassung von Strahlung von Wärmequellen eingesetzt werden, beispielsweise um mittels des optischen Sensors ein Wärmebild einer Umgebung des optischen Sensors zu erstellen, eine Geste zu erkennen oder die Temperatur eines Objekts zu messen. Entsprechend kann es sich bei dem Parameter einer zweiten elektromagnetischen Strahlung um eine Messgröße einer Wärmestrahlung, und damit einer elektromagnetischen Strahlung im langwelligeren Bereich, handeln. Die Auswerteeinheit kann beispielsweise in Form eines ASIC vorliegen, und ausgebildet sein, um den ersten und zweiten Parameter mittels geeigneter Algorithmen zu verarbeiten und entsprechende Ergebnisse über eine geeignete Schnittstelle an einen mit dem optischen Sensor gekoppelten Bildgeber auszugeben. Bei dem Kavernenbereich kann es sich um einen gasdichten Raum zwischen dem Fotometerelement und der Auswerteeinheit handeln, in dem eine definierte Gasatmosphäre (Druck, Gaszusammensetzung) herrscht.

Gemäß einer Ausführungsform des optischen Sensors können die Auswerteeinheit, der Kavernenbereich mit dem Infrarot-Sensorelement und das Fotometerelement einen Stapel bildend übereinander angeordnet sein. Dabei kann das Fotometerelement näher an einer Außenseite des optischen Sensors angeordnet sein, als das Infrarot-Sensorelement. So kann ohne Weiteres gewährleistet werden, dass die erste - kurzwelligere - elektromagnetische Strahlung unbehindert auf das Fotometerelement auftrifft und möglichst unverfälscht erfasst werden kann.

Beispielsweise kann das Infrarot-Sensorelement an einer dem Kavernenbereich zugewandten Hauptseite des Fotometerelements angeordnet sein. Diese Ausführungsform ermöglicht eine vorteilhafte Einbettung des Infrarot-Sensorelements in ein Substrat des Fotometerelements. Eine Fertigung eines kombinierten Kappenchips mit einem Fotometer- und einem Infrarot-Sensorbereich kann die Herstellungskosten des optischen Sensors senken und den benötigten Bauraum auf der Leiterplatte verringern.

Alternativ kann das Infrarot-Sensorelement an einer dem Kavernenbereich zugewandten Hauptseite der Auswerteeinheit angeordnet sein. Diese Ausführungsform bietet den Vorteil, dass auf Leitungen zur elektrischen und datentechnischen Anbindung des Infrarot-Sensorelements an die Auswerteeinheit verzichtet werden kann. So können Bauraum und Kosten eingespart werden.

Beispielsweise kann das Infrarot-Sensorelement als ein Bolometerelement und/oder ein Pyrometerelement und/oder ein Infrarot-Sensorelement zur Erfassung einer elektromagnetischen Strahlung im ferninfraroten Wellenlängenbereich ausgebildet sein. Ein derartiges Infrarot-Sensorelement kann vorteilhafterweise in den unterschiedlichsten Bereichen der Strahlenmessung eingesetzt werden.

Ferner kann die dem Kavernenbereich zugewandte Hauptseite des Fotometerelements eine Ausnehmung aufweisen. Mit dieser Ausführungsform kann der Kavernenbereich an dem Infrarot-Sensorelement auf einfache Weise vergrößert werden. Dies bringt den Vorteil mit sich, dass eine Wärmeübertragung von an das Infrarot-Sensorelement angrenzenden Bereichen des optischen Sensors auf das Infrarotlnfrarot-Sensorelement, was zu einer Verfälschung der Messwerte des Infrarot-Sensorelements führen könnte, wirksam vermieden werden kann.

Gemäß einer Ausführungsform kann in dem Kavernenbereich ein Vakuum oder eine Inertgasatmosphäre eingeschlossen sein. So kann unterwünschte Strahlung auf einfache Weise von dem Infrarot-Sensorelement ferngehalten werden.

Gemäß einer Ausführungsform kann das Fotometerelement als eine in einem Halbleitermaterial des optischen Sensors ausgebildete Fotodiode mit einem dotierten Bereich mit zumindest einem ersten Bereich, der eine erste Dotierung aufweist und einem zweiten Bereich, der eine sich von der ersten Dotierung unterscheidende zweite Dotierung aufweist, ausgebildet sein. Dabei kann insbesondere der dotierte Bereich auf einer von dem Kavernenbereich abgewandten weiteren Hauptseite des Fotometerelements angeordnet sein. Auch diese Ausführungsform des optischen Sensors ermöglicht eine möglichst lückenlose und störungsfreie Erfassung der ersten elektromagnetischen Strahlung durch das Fotometerelement.

Gemäß einer weiteren Ausführungsform kann die von dem Kavernenbereich abgewandte weitere Hauptseite des Fotometerelements einen Filter aufweisen, der ausgebildet ist, um die zweite elektromagnetische Strahlung auf das Fotometerelement zumindest zu dämpfen. Insbesondere kann das Filter für die zweite elektromagnetische Strahlung undurchlässig sein. Das Filter kann beispielsweise in eine auf die weitere Hauptseite des Fotometerelements aufgebrachte Metallisierungsschicht eingearbeitet sein. Mit dieser Ausführungsform kann auf einfache Weise eine Störung der Messfunktionalität des Fotometerelements durch einen auf den optischen Sensor auftreffenden Anteil zweiter elektromagnetischer Strahlung vorteilhaft verhindert werden. Insbesondere können der dotierte Bereich und/oder das Filter einen dem Infrarot-Sensorelement gegenüberliegenden Öffnungsbereich aufweisen. Der Öffnungsbereich kann für die zweite elektromagnetische Strahlung zumindest teilweise transparent ausgebildet sein. So kann auf einfache, kostengünstige und Bauraum sparende Weise eine für die Funktionalität des Infrarot-Sensorelements geeignete Apertur des optischen Sensors realisiert werden.

Ferner können das Fotometerelement und/oder die Auswerteeinheit zumindest einen elektrischen Durchkontakt für eine elektrisch leitfähige Anbindung des optischen Sensors an ein Trägerelement des optischen Sensors aufweisen. Mit dieser Ausführungsform kann vorteilhaft auf Bonddrähte verzichtet und so eine möglichst kleine Bauform des optischen Sensors realisiert werden.

Es wird ferner ein Verfahren zum Herstellen eines optischen Sensors vorgestellt, wobei das Verfahren die folgenden Schritte aufweist:
Bereitstellen eines Fotometerelements zum Erfassen zumindest eines Parameters einer ersten elektromagnetischen Strahlung, eines Infrarot-Sensorelements zum Erfassen zumindest eines Parameters einer zweiten elektromagnetischen Strahlung und einer Auswerteeinheit zum Auswerten des Parameters der ersten elektromagnetischen Strahlung und/oder des Parameters der zweiten elektromagnetischen Strahlung; und

Bonden des Fotometerelements unter Bildung eines Kavernenbereichs zwischen der Auswerteeinheit und dem Fotometerelement, sodass das Infrarot-Sensorelement in dem Kavernenbereich eingeschlossen wird.

Das Verfahren kann im Rahmen einer computergesteuerten Fertigungsstraße zur kostengünstigen und zeitsparenden Produktion einer Vielzahl der hier vorgestellten optischen Sensoren ausgeführt werden. Auch durch diese Ausführungsvariante der Erfindung in Form eines Herstellungsverfahrens kann die der Erfindung zugrunde liegende Aufgabe schnell und effizient gelöst werden.

Der hier vorgestellte Ansatz wird nachstehend anhand der beigefügten Zeichnungen beispielhaft näher erläutert. Es zeigen:
Fig. 1 eine Prinzipdarstellung eines herkömmlichen Infrarot-Sensors gemäß dem Stand der Technik;
Fig. 2 eine Prinzipdarstellung eines optischen Sensors gemäß einem Ausführungsbeispiel der vorliegenden Erfindung;
Fig. 3 eine Prinzipdarstellung eines optischen Sensors gemäß einem weiteren Ausführungsbeispiel der vorliegenden Erfindung; und
Fig. 4 ein Ablaufdiagramm eines Verfahrens zum Herstellen eines optischen Sensors, gemäß einem Ausführungsbeispiel der vorliegenden Erfindung.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

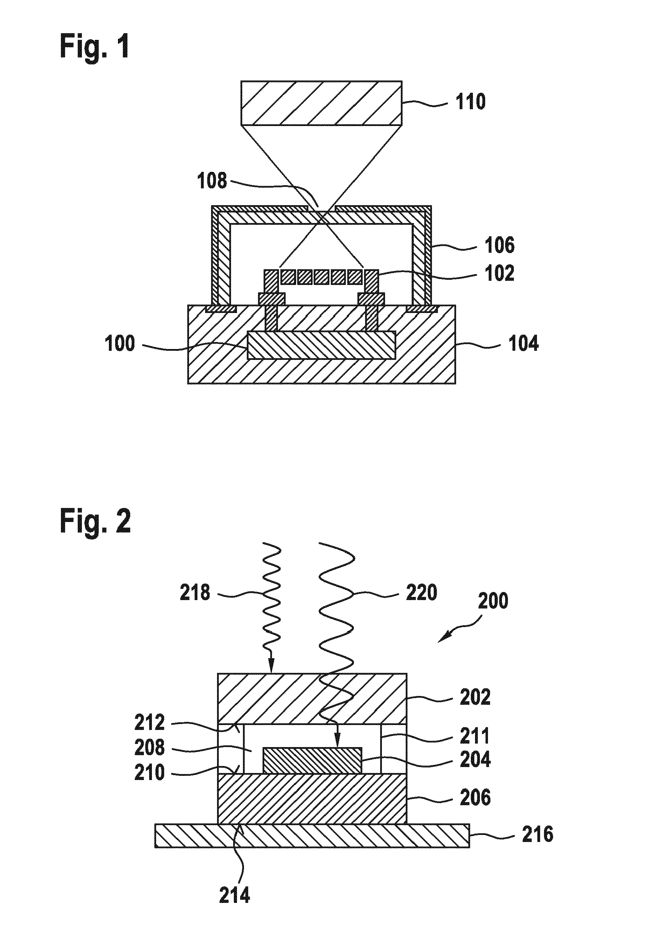

Fig. 1 zeigt eine Prinzipdarstellung eines herkömmlichen Infrarot-Sensors gemäß dem Stand der Technik. Gezeigt ist der prinzipielle Aufbau eines ALD-Infrarot-Sensors. Ein mit einem ASIC 100 gekoppeltes Infrarot-Sensorelement 102 ist auf einem Substrat 104 angeordnet und mit einer Kappe 106 hermetisch eingeschlossen. Über eine Apertur 108 in der Kappe 106 erfasst das Infrarot-Sensorelement 102 eine elektromagnetische Strahlung eines gegenüber dem Infrarot-Sensor befindlichen Objekts 110.
Fig. 2 zeigt anhand einer Prinzipdarstellung einen optischen Sensor 200 gemäß einem Ausführungsbeispiel der vorliegenden Erfindung. Der optische Sensor 200 umfasst in Form eines Sensorclusters ein Fotometerelement 202, ein Infrarot-Sensorelement 204 sowie eine Auswerteeinheit 206. Das Infrarot-Sensorelement 204 ist bei dem in Fig. 2 gezeigten Ausführungsbeispiel des optischen Sensorclusters 200 in einem zwischen Fotometerelement 202 und der Auswerteeinheit 206 gebildeten Kavernenbereich 208 an einer dem Kavernenbereich 208 zugewandten Hauptseite 210 der Auswerteeinheit 206 angeordnet. Die Substrate des Fotometers 202 und der Auswerteeinheit 206 sind über einen Bondrahmen 211 mechanisch und ggf. über zusätzliche Bondkontakte elektrisch miteinander verbunden. Gemäß einem alternativen Ausführungsbeispiel kann das Infrarot-Sensorelement 204 auch an einer dem Kavernenbereich 208 zugewandten Hauptseite 212 des Fotometerelements 202 angeordnet sein.

Wie die Darstellung in Fig. 2 zeigt, ist der optische Sensor 200 stapelförmig aufgebaut, wobei die Auswerteeinheit 206 eine Basis des Stapels bildet, auf der sich der Kavernenbereich 208 mit dem Infrarot-Sensorelement 204 befindet. Oberhalb des Kavernenbereichs 208 liegt hier abschließend als Oberseite des Stapels und damit Außenseite des optischen Sensors 200 das Fotometerelement 202. Mit einer der Hauptseite 210 gegenüberliegenden weiteren Hauptseite 214 der Auswerteeinheit 206 ist der beispielhafte optische Sensorcluster 200 in Fig. 2 an einem Trägerelement 216 befestigt und mit diesem elektrisch verbunden. Entsprechend dem Aufbau des optischen Sensors 200 befindet sich das Infrarot-Sensorelement 204 näher bei dem Trägerelement 216 und damit weiter von einer Außenseite des Sensors 200 entfernt als das Fotometerelement 202.

Das Fotometerelement 202 ist ausgebildet, um zumindest einen Parameter einer ersten elektromagnetischen Strahlung 218 zu erfassen, und das Infrarot-Sensorelement 204 ist ausgebildet, um zumindest einen Parameter einer zweiten elektromagnetischen Strahlung 220 zu erfassen. Die Auswerteeinheit 206 ist ausgebildet, um über geeignete Schnittstellen mit dem Fotometerelement 202 sowie dem Infrarot-Sensorelement 204 Messdaten des Fotometerelements 202 und des Infrarot-Sensorelements 204 zu empfangen und auszuwerten. Gemäß dem Aufbau des optischen Sensors 200 ist das näher an der Außenseite des Sensors 200 angeordnete Fotometermeterelement 202 ausgebildet, um die kurzwelligere erste elektromagnetische Strahlung 218 wie z. B. sichtbares Licht und/oder UV-Licht zu erfassen, während das weiter von der Außenseite des Sensors 200 entfernte Infrarot-Sensorelement 204 ausgebildet ist, um die langwelligere zweite elektromagnetische Strahlung 220 wie z. B. Infrarotlicht und/oder Ferninfrarotlicht zu erfassen. Der Kavernenbereich 208, an bzw. in dem das Infrarot-Sensorelement 204 angeordnet ist, gewährleistet, dass die Messfunktionalität des Infrarot-Sensors 204 nicht durch Wärmeabstrahlung des Fotometerelements 202 und/oder der Auswerteeinheit 206 und/oder von atmosphärischer Feuchtigkeit beeinträchtigt wird.

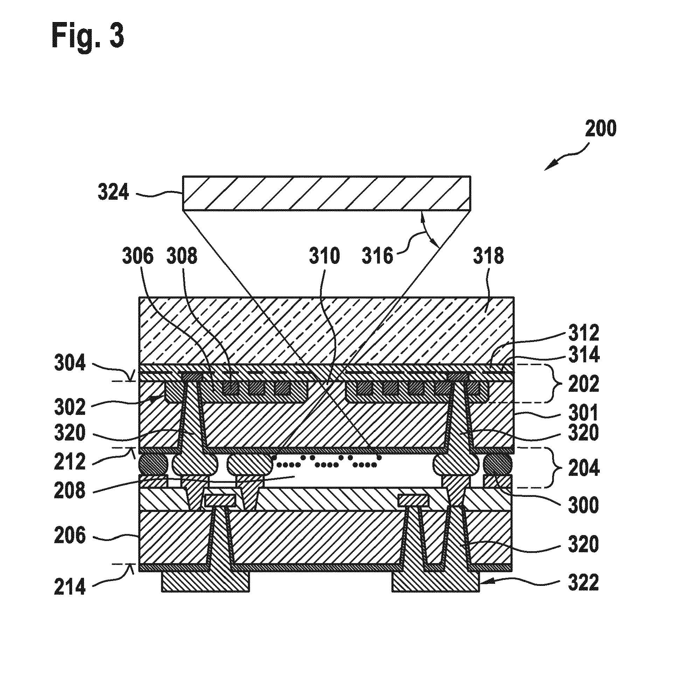

Fig. 3 zeigt in einer detailgenaueren Prinzipdarstellung einen Schnitt durch ein weiteres Ausführungsbeispiel des hier vorgestellten optischen Sensorclusters 200 für Umgebungs- und Ferninfrarotlicht. Wiederum ist der optische Sensor 200 als Stapel aufgebaut, in dem die Auswerteeinheit 206 die Basis bildet, auf der die Kavität bzw. der Kavernenbereich 208 mit dem Infrarot-Sensorelement 204 und auf diesem wiederum das Fotometerelement 202 angeordnet ist. Die Auswerteeinheit 206 ist hier als ASIC ausgeführt. Das Infrarot-Sensorelement 204, von dem in der Darstellung in Fig. 3 stellvertretend lediglich einige wenige Detektorpixel gezeigt sind, ist hier an der dem Kavernenbereich 208 zugewandten Hauptseite 212 des Fotometerelements 202 angeordnet. Ein zwischen dem Fotometer-Sensor 202 und dem Auswertechip 206 angeordneter Dichtring 300 sorgt für einen gasdichten Verschluss der Kavität 208.

Der Fotometersensor 202 ist hier als eine in einem Halbleitermaterial bzw. Kappenchip 301 des optischen Sensors 200 ausgebildete Fotodiode mit einem dotierten Bereich 302 an einer von dem Kavernenbereich 208 abgewandten weiteren Hauptseite 304 des Fotometerelements 202 ausgebildet. Das Halbleitermaterial 301 kann aus Silizium bestehen oder Silizium aufweisen. Der dotierte Bereich 302 setzt sich aus einer ersten Dotierung 306 und einer sich von der ersten Dotierung unterscheidenden zweiten Dotierung 308 zusammen. Bei dem in Fig. 3 gezeigten Ausführungsbeispiel des kombinierten optischen Sensors 200 erstreckt sich der dotierte Bereich 302 schichtartig über einen Großteil der weiteren Hauptseite 304 des Fotometerelements 202 und weist in der Mitte eine Öffnung bzw. Apertur 310 auf.

Bei dem in Fig. 3 gezeigten Ausführungsbeispiel des optischen Sensors 200 ist der das Fotometerelement bildende Sensorchip 202 nach außen von einer Metallisierungsschicht 312 abgedeckt, in die ein Filter 314 eingearbeitet ist. Das Filter 314 ist ausgebildet, um verschiedene Wellenlängen der ersten elektromagnetischen Strahlung separat detektieren zu können und ggf. ein Auftreffen der zweiten elektromagnetischen Strahlung auf das Fotometerelement 202 zu verhindern. Die Öffnung bzw. Apertur 310 ist auch in der Metallisierungslage 312 mit dem Filter 314 ausgebildet und ermöglicht einen Durchtritt der zweiten bzw. langwelligen elektromagnetischen Strahlung durch die oberen Schichten des Sensors 200 zu den Detektorpixeln des Infrarot-Sensorelements 204 in einem durch eine Größe der Apertur 310, die Substratdicke des Fotometersensors 202 und die Größe der Pixelmatrix des Infrarot-Sensors 204definierten Raumwinkel 316. Bei der langwelligen elektromagnetischen Strahlung handelt es sich beispielsweise um elektromagnetische Strahlung im Ferninfrarotbereich bzw. FIR-Strahlung.

Bei dem in der Darstellung in Fig. 3 gezeigten Ausführungsbeispiel des Sensorclusters 200 wird die oberste bzw. äußerste Lage des Stapels von einem Deckglas 318 zum Schutz vor Beschädigung bzw. Verunreinigung. Bei alternativen Ausführungsbeispielen kann auf das Deckglas 318 auch verzichtet werden. Sowohl das Fotometerelement 202 als auch die Auswerteeinheit 206 des beispielhaften Sensors 200 sind im dargestellten Ausführungsbeispiel mit Durchkontakten bzw. TSVs (TSV; Through-Silicon-Via = Silizium-Durchkontaktierung) 320 zur elektrischen Anbindung des Sensors 200 an ein hier nicht gezeigtes Trägerelement ausgestattet. Über an der weiteren Hauptseite 214 der Auswerteeinheit 206 angeordnete Kontaktpads 322 kann der Sensor 200 beispielsweise an einen Träger angebunden werden. Wie die Darstellung in Fig. 3 zeigt, ist der optische Sensor 200 auf ein von dem Sensor 200 beabstandetes heißes Objekt 324 ausgerichtet, um Parameter der von dem Objekt 324 ausgehenden ersten und zweiten elektromagnetischen Strahlung zu erfassen.

Der in Fig. 3 beispielhaft gezeigte optische Sensorcluster 200 setzt sich aus dem Auswerteschaltungschip 206, dem damit verbundenen Kappenchip 301 mit dem Fotometer 202 und dem dazwischen in der hermetisch dichten Kavernenkaverne 208 eingeschlossenen Infrarot-Sensordetektorelement 204 für die FIR-Detektion zusammen. Gemäß Ausführungsbeispielen kann die Kaverne 208 auch eine Mehrzahl von Infrarot-Sensordetektorelementen 204 aufweisen. Das Infrarot-Sensorelement 204 ist hier innerhalb der Kavität 208 auf dem Kappenchip 301 integriert, kann aber alternativ auch auf dem Auswerteschaltungschip 206 integriert sein. Bei dem in Fig. 3 gezeigten Ausführungsbeispiel weisen sowohl der ASIC 206 als auch der Kappenchip 301 Waferdurchkontakte bzw. TSVs 320 auf. In den Kappenchip 301 ist auf seiner nach außen weisenden Seite 304 das Fotometer 202 für kürzere Wellenlängen integriert. Für das Fotometer 202 sind die verschieden dotierten Bereiche 306 und 308 beispielsweise als p-n-Übergänge im Kappensubstrat 301 vorgesehen.

Wie die Darstellung in Fig. 3 zeigt, bedeckt bei dem beispielhaften Sensorcluster 200 die Metallisierung 312 des an der nach außen weisenden Seite 304 des Kappenchips 301 befindlichen Fotometers 202 einen Großteil der Oberfläche des Kappenchips 301. Dabei ist in der Metallisierung 312 direkt im Bereich der Infrarot-Sensordetektorelemente 204 mit der Aussparung bzw. Öffnung 310 ein Bereich vorgesehen, der für Ferninfrarotstrahlung durchlässig ist. Wie die Darstellung zeigt, ist im selben Bereich im Kappensubstrat 301 keine Dotierung 302 vorhanden. Gemäß in den Figuren nicht gezeigten Ausführungsbeispielen des optischen Sensorclusters 200 kann zur vorteilhaften Vergrößerung der Kavität 208 im Kappenchip 301 auf der innenliegenden Seite 202 eine Ausnehmung vorgesehen sein.

Eine vorteilhafte weil kleinstmögliche Bauform ist der in Fig. 3 gezeigte optische Sensorcluster 200 im Chipscale-Package (CSP), das den Auswerteschaltungschip 206 und den Kappenchip 301 umfasst. Die Waferdurchkontakte bzw.TSVs 320 durch ASIC 206 und Kappenchip 301 ermöglichen hier eine Kontaktierung des CSP-Sensorclusters 200 ohne Bonddrähte und damit eine minimale Baugröße des Sensorclusters 200.

Für die Infrarot-Sensorfunktion wird die hermetisch dichte Kavität 208 benötigt, um im Falle eines Bolometers eine Wärmekopplung zwischen Infrarot-Sensordetektorelementen 204 und Substrat 301 durch Gaswärmeleitung zu verhindern bzw. im Falle eines Pyrometers durch Feuchtigkeit begünstigte oberflächlich fließende Leckströme zu unterbinden. Die Integration des Infrarot-Sensordetektorelements 204 auf dem Silizium-Kappenchip 301, wie bei dem in Fig. 3 gezeigten Ausführungsbeispiel realisiert, wird über eine Umkontaktierung auf das ASIC 206 ermöglicht. Niedrigdotiertes Silizium ist für Ferninfrarotlicht im Wesentlichen durchlässig. Da kurzwellige Strahlung im sichtbaren und UV-Bereich im Silizium stark absorbiert wird, ist die Integration des Fotometers 202 in den Kappenchip 301 auf seiner nach außen weisenden Seite 304 sinnvoll.

Bei dem in Fig. 3 gezeigten beispielhaften optischen Sensorcluster 200 ist das Fotometer 202 günstig als einfache Fotodiode im Kappensubstrat 301 vorgesehen. Die mit den verschieden dotierten Bereichen 306, 308 verbundenen internen elektrischen Felder der Fotodiode sorgen für eine Trennung der fotogenerierten Ladungsträger in Elektronen und Löcher. Um eine Schwächung des Ferninfrarotlichts durch freie Ladungsträgerabsorption im Kappensubstrat 301 weitgehend zu vermeiden, ist das Kappensubstrat 301 vorteilhaft im Durchtrittsbereich 310 des Ferninfrarotlichtkegels undotiert.

Für die Darstellung einer wellenlängenselektiven Empfindlichkeit des Fotometers 202 ist bei dem in Fig. 3 gezeigten Ausführungsbeispiel in der Metallisierung 312 das Filter 314 realisiert, das einen Großteil der Oberfläche des Fotometers 202 bedeckt und so die Durchdringung des Fotometers 202 mit Ferninfrarotstrahlung in Verbindung mit den Dotierungsbereichen verhindert. Für den Infrarot-Sensor 204 ist die Einschränkung des Sichtfeldes über die Apertur 310 wünschenswert, um linsenfrei und damit kostengünstig den Raumwinkel 316 einschränken zu können. Auf diese Weise lässt sich störende diffuse Strahlung bei der Temperaturmessung des Objektes 324 in einem Bildausschnitt ausblenden. Die Aussparungen 310 in Metallisierung und Dotierung sind sinnvollerweise direkt im Bereich der Infrarot-Sensorpixel 204 vorgesehen. Für eine optimale Funktionalität des Infrarot-Sensorelements 204 sind die Dicke der Kappe 301, der Durchmesser des Öffnungsbereichs 310 und der Durchmesser des Infrarot-Sensorpixelbereichs 204 exakt aufeinander abgestimmt.

Zum Schutz vor äußeren Einflüssen und als Antireflexionselement ist bei dem in Fig. 3 gezeigten Ausführungsbeispiel des optischen Sensors 200 auf dem Fotometer 202 optional ein Deckglas 318 vorgesehen.

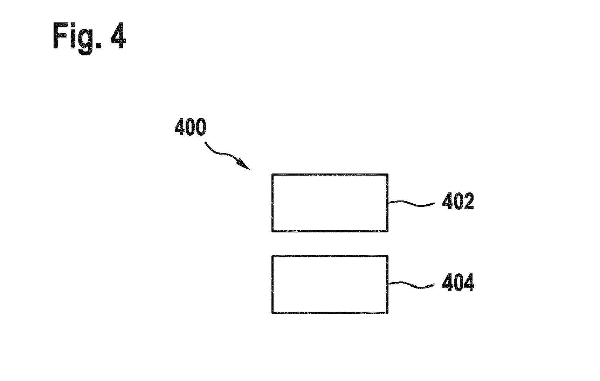

Fig. 4 zeigt ein Ablaufdiagramm eines Ausführungsbeispiels eines Verfahrens 400 zum Herstellen eines optischen Sensors. Das Verfahren 400 kann zur Herstellung eines optischen Sensors wie in den Figuren 2 und 3 gezeigt, beispielsweise in einer automatisierten Fertigungsstraße, ausgeführt werden. In einem Schritt 402 werden zumindest ein Fotometerelement zum Erfassen von Parametern einer ersten elektromagnetischen Strahlung, zumindest ein Infrarot-Sensorelement zum Erfassen von Parametern einer zweiten elektromagnetischen Strahlung sowie eine Auswerteeinheit zum Auswerten der Parameter der ersten und/oder der zweiten elektromagnetischen Strahlung bereitgestellt. In einem Schritt 404 wird das zumindest eine Infrarot-Sensorelement unter Bildung eines Kavernenbereichs zwischen dem zumindest einen Fotometerelement und der Auswerteeinheit an einer dem Kavernenbereich zugewandten Hauptseite des zumindest einen Fotometerelements oder einer dem Kavernenbereich zugewandten Hauptseite der Auswerteeinheit angeordnet.

Das hierin vorgestellte Konzept ermöglicht die Herstellung eines kombinierten Strahlungssensors für Strahlung im Ferninfrarot-Wellenlängenbereich und im kurzwelligen Wellenlängenbereich des sichtbaren Lichts und/oder des UV-Lichts. Ein möglicher Einsatz besteht in mobilen Endgeräten wie beispielsweise Mobiltelefonen.

Die beschriebenen und in den Figuren gezeigten Ausführungsbeispiele sind nur beispielhaft gewählt. Unterschiedliche Ausführungsbeispiele können vollständig oder in Bezug auf einzelne Merkmale miteinander kombiniert werden. Auch kann ein Ausführungsbeispiel durch Merkmale eines weiteren Ausführungsbeispiels ergänzt werden.

Ferner können die hier vorgestellten Verfahrensschritte wiederholt sowie in einer anderen als in der beschriebenen Reihenfolge ausgeführt werden.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Optischer Sensor (200) mit einem Fotometerelement (202) zum Erfassen zumindest eines Parameters einer ersten elektromagnetischen Strahlung (218), einem Infrarot-Sensorelement (204) zum Erfassen zumindest eines Parameters einer zweiten elektromagnetischen Strahlung (220) und einer Auswerteeinheit (206) zum Auswerten des Parameters der ersten elektromagnetischen Strahlung (218) und/oder des Parameters der zweiten elektromagnetischen Strahlung (220), wobei das Infrarot-Sensorelement (204) in und/oder an einem zwischen dem Fotometerelement (202) und der Auswerteeinheit (206) gebildeten Kavernenbereich (208) angeordnet ist.

2. Optischer Sensor (200) gemäß Anspruch 1, **dadurch gekennzeichnet, dass** die Auswerteeinheit (206), der Kavernenbereich (208) mit dem Infrarot-Sensorelement (204) und das Fotometerelement (202) einen Stapel bildend übereinander angeordnet sind, wobei das Fotometerelement (202) näher an einer Außenseite des optischen Sensors (200) angeordnet ist, als das Infrarot-Sensorelement (204).

3. Optischer Sensor (200) gemäß einem der vorangegangenen Ansprüche, **dadurch gekennzeichnet, dass** das Infrarot-Sensorelement (204) an einer dem Kavernenbereich (208) zugewandten Hauptseite (212) des Fotometerelements (202) angeordnet ist.

4. Optischer Sensor (200) gemäß Anspruch 1 oder 2, **dadurch gekennzeichnet, dass** das Infrarot-Sensorelement (204) an einer dem Kavernenbereich (208) zugewandten Hauptseite (210) der Auswerteeinheit (206) angeordnet ist.

5. Optischer Sensor (200) gemäß einem der vorangegangenen Ansprüche, **dadurch gekennzeichnet, dass** das Infrarot-Sensorelement (204) als ein Bolometerelement und/oder ein Pyrometerelement und/oder ein Infrarot-Sensorelement zur Erfassung einer elektromagnetischen Strahlung im ferninfraroten Wellenlängenbereich ausgebildet ist.

6. Optischer Sensor (200) gemäß einem der vorangegangenen Ansprüche, **dadurch gekennzeichnet, dass** die dem Kavernenbereich (208) zugewandte Hauptseite (212) des Fotometerelements (202) eine Ausnehmung aufweist.

7. Optischer Sensor (200) gemäß einem der vorangegangenen Ansprüche, **dadurch gekennzeichnet, dass** in dem Kavernenbereich (208) ein Vakuum oder eine Inertgasatmosphäre eingeschlossen ist.

8. Optischer Sensor (200) gemäß einem der vorangegangenen Ansprüche, **dadurch gekennzeichnet, dass** das Fotometerelement (202) als eine in einem Halbleitermaterial (301) des optischen Sensors (200) ausgebildete Fotodiode mit zumindest einem dotierten Bereich (302) mit einem ersten Bereich (306), der eine erste Dotierung (306) aufweist, und einem zweiten Bereich (308), in dem eine sich von der ersten Dotierung (306) unterscheidende zweite Dotierung (308) ausgebildet ist, insbesondere wobei der dotierte Bereich (302) auf einer von dem Kavernenbereich (208) abgewandten weiteren Hauptseite (304) des Fotometerelements (202) angeordnet ist.

9. Optischer Sensor (200) gemäß einem der vorangegangenen Ansprüche, **gekennzeichnet durch** ein Filter (314), das ausgebildet ist, um die zweite elektromagnetische Strahlung (220) auf das Fotometerelement (202) zumindest zu dämpfen, insbesondere wobei das Filter (314) für die zweite elektromagnetische Strahlung (220) undurchlässig ist.

10. Optischer Sensor (200) gemäß Anspruch 7, **dadurch gekennzeichnet, dass** der dotierte Bereich (302) und/oder das Filter (314) einen dem Infrarot-Sensorelement (204) gegenüberliegenden Öffnungsbereich (310) aufweist, der für die zweite elektromagnetische Strahlung (220) zumindest teilweise transparent und/oder durchlässig ist.

11. Optischer Sensor (200) gemäß einem der vorangegangenen Ansprüche, **dadurch gekennzeichnet, dass** das Fotometerelement (202) und/oder die Auswerteeinheit (206) zumindest einen elektrischen Durchkontakt (320) für eine elektrisch leitfähige Anbindung des optischen Sensors (200) an ein Trägerelement (216) des optischen Sensors (200) aufweisen.

12. Verfahren (400) zum Herstellen eines optischen Sensors (200), wobei das Verfahren (400) die folgenden Schritte aufweist:
Bereitstellen (402) eines Fotometerelements (202) zum Erfassen zumindest eines Parameters einer ersten elektromagnetischen Strahlung (218), eines Infrarot-Sensorelements (204) zum Erfassen zumindest eines Parameters einer zweiten elektromagnetischen Strahlung (220) und einer Auswerteeinheit (206) zum Auswerten des Parameters der ersten elektromagnetischen Strahlung (218) und/oder des Parameters der zweiten elektromagnetischen Strahlung (220); und
Bonden (404) des Fotometerelements (202) unter Bildung eines Kavernenbereichs (208) zwischen der Auswerteeinheit (206) und dem Fotometerelement (202), sodass das Infrarot-Sensorelement (204) in dem Kavernenbereich (208) eingeschlossen wird.
